Europäisches Patentamt

European Patent Office

Office européen des brevets

(19)

(11) EP 0 722 093 A1

(12) **EUROPÄISCHE PATENTANMELDUNG**

(43) Veröffentlichungstag:
17.07.1996 Patentblatt 1996/29

(51) Int. Cl.⁶: $G01R\ 33/385$, $G01R\ 33/561$

(21) Anmeldenummer: 96100084.1

(22) Anmeldetag: 01.12.1989

(84) Benannte Vertragsstaaten:
DE GB

(30) Priorität: 01.12.1989 EP 89122188

(62) Anmeldenummer der früheren Anmeldung nach Art.
76 EPÜ: 89122188.9

(71) Anmelder: SIEMENS AKTIENGESELLSCHAFT
80333 München (DE)

(72) Erfinder:
• Nowak, Stefan, Dipl.-Ing. (FH)
D-91056 Erlangen (DE)
• Schmitt, Franz, Dipl-Phys.
D-91083 Baiersdorf (DE)
• Fischer, Hubertus, Dipl.-Phys.
D-91054 Erlangen (DE)

Bemerkungen:
This application was filed on 04 - 01 - 1996 as a divisional application to the application mentioned under INID code 62.

(54) **Verfahren zum Betrieb eines Kernspintomographiegeräts mit einem Resonanzkreis zur Erzeugung von Gradientenfeldern**

(57)    Die Gradientenspule (30) zur Erzeugung des periodisch wechselnden Auslesegradienten (RO) wird in einem Serienresonanzkreis mit einem Kondensator (20) betrieben. Vor Auslesegradienten (RO) wird der Kondensator (20) des Serienresonanzkreises im resonanten Betrieb aufgeladen. Durch die Verwendung eines Serienresonanzkreises anstelle eines Parallelresonanzkreises wie beim Stand der Technik wird die Spannungsbelastung des Gradientenverstärkers deutlich reduziert, so daß dieser einfacher und billiger aufzubauen ist.

FIG 12

## Beschreibung

Die Erfindung betrifft ein Verfahren zum Betrieb eines Kernspintomographiegeräts mit einer Pulssequenz, bei der je Scan nach einer Anregung eine Auslesesequenz folgt, bei der mindestens zwei senkrecht aufeinander stehende Gradienten zur Ortskodierung eingeschaltet werden, wobei die entstehenden Signale digitalisiert und im K-Raum in eine Rohdatenmatrix eingeschrieben werden, wobei aus der Rohdatenmatrix durch eine mindestens zweidimensionalen Fouriertransformation ein Bild gewonnen wird, wobei mindestens eine Gradientenspule mit mindestens einem Kondensator zu einem Resonanzkreis zusammengeschaltet ist, der an einen Gradientenverstärker angeschlossen ist, wobei der Gradientenverstärker nach einer vorbestimmten Zeitfunktion angesteuert wird.

Ein derartiges Verfahren ist aus dem Dokument EP 0 227 411 bekannt. Dabei werden durch Verwendung eines Parallelresonanzkreises zur Erzeugung von Gradientenpulsen die ansonsten bei schnellen Pulssequenzen extrem hohen Leistungsanforderungen an den Gradientenverstärker vermindert. Vor Beginn einer Pulssequenz wird der Kondensator durch eine Hilfsspannungsquelle aufgeladen, die einen Teil der benötigten Spitzenspannung aufbringt. Der restliche Teil wird ausgehend von einer - z.B. mittels einer Hilfsspannungsquelle $V_1$ - stromgeladenen Schwingkreisspule durch Resonanzbetrieb vor Beginn der eigentlichen Sequenz aufgebracht. Die im Kondensator gespeicherte Energie wird nötigenfalls mittels einer weiteren Hilfsspannungsquelle $V_3$ aufrechterhalten.

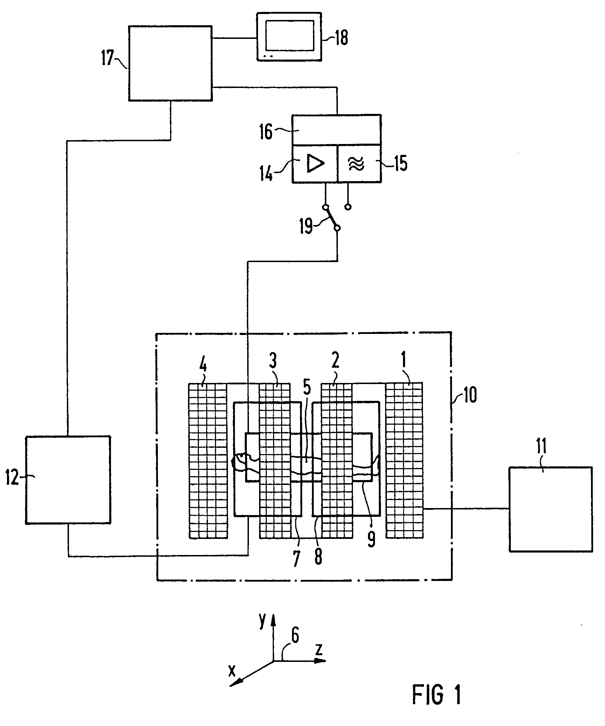

Zur Erlauterung der Problemstellung sind in FIG 1 die Grundkomponenten eines Kernspintomographiegerätes schematisch dargestellt. Die Spulen 1 bis 4 erzeugen ein magnetisches Grundfeld B0, in welchem sich bei Anwendung zur medizinischen Diagnostik der zu untersuchende Körper eines Patienten 5 befindet. Diesem sind außerdem Gradientenspulen zugeordnet, die zur Erzeugung unabhängiger, zueinander senkrechter Magnetfeldkomponenten der Richtungen x, y und z gemäß dem Koordinatenkreuz 6 vorgesehen sind. In der FIG 1 sind der übersichtlichkeit halber nur die Gradientenspulen 7 und 8 gezeichnet, die zusammen mit einem Paar gegenüberliegender, gleichartiger Gradientenspulen zur Erzeugung eines x-Gradienten dienen. Die gleichartigen, nicht eingezeichneten y-Gradientenspulen liegen parallel zum Körper 5 und oberhalb sowie unterhalb von ihm, die für das z-Gradientenfeld quer zu seiner Längsachse am Kopf- und am Fußende.

Die Anordnung enthält außerdem noch eine zur Erzeugung und Aufnahme der Kernresonanzsignale dienende Antenne 9. Die von einer strichpunktierten Linie 10 umgrenzten Spulen 1, 2, 3, 4, 7, 8 und 9 stellen das eigentliche Untersuchungsinstrument dar. Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfaßt. Die Hochfrequenzspule 9 ist über einen Signalverstärker 14 bzw. einen Hochfrequenzsender 15 an einen Prozeßrechner 17 gekoppelt, an den zur Ausgabe der Abbildung ein Bildschirmgerät 18 angeschlossen ist. Die Komponenten 14 und 15 bilden eine Hochfrequenzeinrichtung 16 zur Signalerzeugung und -aufnahme. Ein Umschalter 19 ermöglicht das Umschalten von Sende- auf Empfangsbetrieb.

Für die Ansteuerung der Hochfrequenzeinrichtung 16 und der Gradientenspulen sind eine Reihe von Pulssequenzen bekannt. Dabei haben sich Verfahren durchgesetzt, bei denen die Bilderzeugung auf einer zwei- bzw. dreidimensionalen Fouriertransformation beruht. Die erfindungsgemäße Schaltung läßt sich besonders vorteilhaft beim bekannten Echoplanar(EPI-)Verfahren einsetzen. Das Prinzip der Bilderzeugung nach dem EPI-Verfahren wird im folgenden anhand der FIG 2 bis 8 kurz erläutert. Eine detaillierte Beschreibung findet sich in der EP-B1-0 076 054.

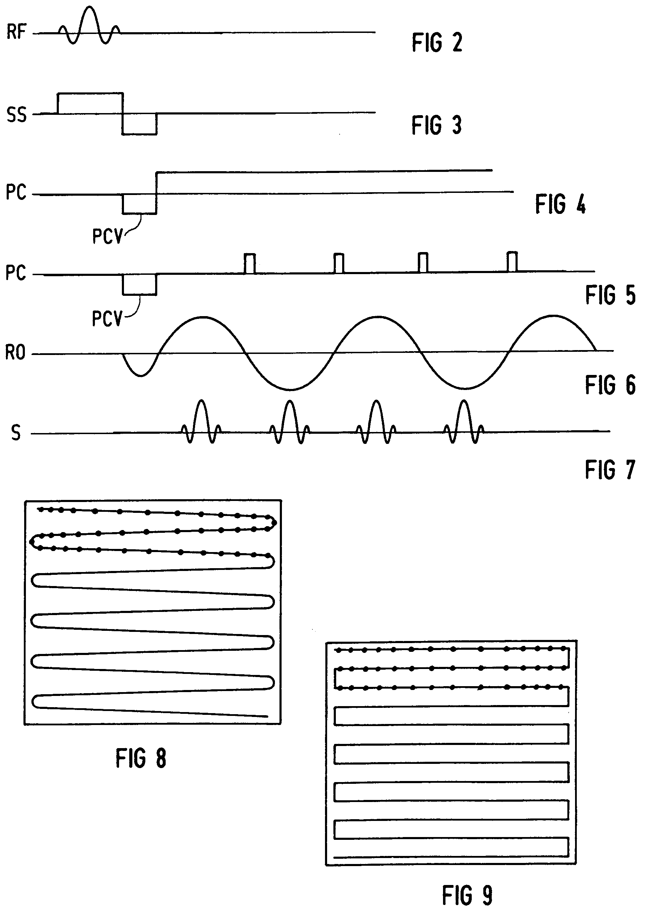

Die FIG 2 bis 7 stellen ein Beispiel für eine beim EPI-Verfahren angewandte Pulssequenz dar. Ein HF-Anregungspuls RF wird zusammen mit einem Gradienten SS in z-Richtung auf das Untersuchungsobjekt eingestrahlt. Damit werden Kernspins in einer Schicht des Untersuchungsobjektes angeregt. Anschließend wird die Richtung des Gradienten SS invertiert, wobei der negative Gradient SS die durch den positiven Gradienten SS verursachte Dephasierung der Kernspins rückgängig macht.

Nach der Anregung wird ein Phasenkodiergradient PC und ein Auslesegradient RO eingeschaltet. Für den Verlauf dieser beiden Gradienten gibt es verschiedene Möglichkeiten. FIG 4 zeigt als erstes Beispiel einen Phasenkodiergradienten PC, der während der Auslesephase kontinuierlich eingeschaltet bleibt. FIG 5 zeigt als Alternative dazu einen Phasenkodiergradienten PC, der aus kurzen Einzelimpulsen ("blips") besteht, die bei jedem Polaritätswechsel des Auslesegradienten RO eingeschaltet werden. Den Phasenkodiergradienten PC geht jeweils ein Vorphasiergradient PCV in negativer Phasenkodierrichtung voraus. Der Auslesegradient RO wird mit ständig wechselnder Polarität eingeschaltet, wodurch die Kernspins im Wechsel dephasiert und wieder rephasiert werden, so daß eine Folge von Signalen S entsteht. Dabei werden nach einer einzelnen Anregung so viele Signale gewonnen, daß der gesamte Fourier-K-Raum abgetastet wird, d.h. daß die vorliegende Information zur Rekonstruktion eines vollständigen Schnittbildes ausreicht. Hierzu ist eine extrem schnelle Umschaltung des Auslesegradienten RO mit hoher Amplitude erforderlich, die mit den sonst bei der MR-Bildgebung üblicherweise angewandten Rechteckimpulsen kaum realisiert werden kann. Einige gebräuchliche Lösung dieses Problems besteht darin, die den Auslesegradienten RO erzeugende Gradientenspule in einem Resonanzkreis zu betreiben, so daß der Auslesegradient RO eine Sinusform aufweist.

Die entstehenden Kernresonanzsignale S werden im Zeitbereich abgetastet, digitalisiert und die so gewonnenen numerischen Werte in eine Rohdatenmatrix eingetragen. Die Rohdatenmatrix kann man als Meßdatenraum, bei dem im Ausführungsbeispiel vorliegenden zweidimensionalen Fall als Meßdatenebene betrachten. Dieser Meßdatenraum wird in der Kernspintomographie als K-Raum bezeichnet. Die Lage der Meßdaten im K-Raum ist in FIG 8 für einen Phasenkodiergradienten PC nach FIG 4, in FIG 9 für einen Phasenkodiergradienten PC nach FIG 5 schematisch dargestellt.

Die für die Bilderzeugung notwendige Information über die räumliche Herkunft der Signalbeiträge ist in den Phasenfaktoren kodiert, wobei zwischen dem Ortsraum (also dem Bild) und dem K-Raum mathematisch der Zusammenhang über eine zweidimensionale Fourier-Transformation besteht. Es gilt:

$$S(k_x, k_y) = \iint \rho\,(x,y)\, e^{i(k_x x + k_y y)}\, dx\, dy$$

Dabei gelten folgende Definitionen:

$$k_x(t) = \gamma \int_0^t G_x(t')dt'\ ;$$

$$k_y(t) = \gamma \int_0^t G_y(t')dt'\ ;$$

$\gamma$　　= gyromagnetisches Verhältnis
$\rho$　　= Kernspindichte
$G_x$　　= Wert des Auslesegradienten RO
$G_y$　　= Wert des Phasenkodiergradienten PC.

Beim EPI-Verfahren sind sehr hohe Gradientenamplituden zur Ortskodierung der NMR-Signale notwendig. Diese hohen Gradientenamplituden müssen in kurzen Zeitabständen (< 1 ms) ein- und ausgeschaltet werden, damit die notwendige Information gewonnen werden kann, bevor das Kernresonanzsignal abklingt. Wegen der Induktivität und des Widerstands der Gradientenspulen lassen sich diese Anforderungen mit einer direkt an einen Gradientenverstärker angeschlossenen Gradientenspule in der Praxis nicht erfüllen. Es wären Anschlußleistungen von ca. 5 MW erforderlich.

Dieses Problem läßt sich dadurch lösen, daß die Gradientenspule mit einem Kondensator zu einem Resonanzkreis zusammengeschaltet wird. In der eingangs genannten EP-A1-0 227 411 und in dem US-Patent 4,628,264 sind Schaltungen beschrieben, bei denen die Gradientenspule in einem Parallelresonanzkreis betrieben wird. Um parasitäre Einschwingvorgänge möglichst kurz zu machen, wird dabei der Resonanzkondensator schon vor der eigentlichen Meßsequenz auf die erforderliche Spannung aufgeladen. Nach Zuschalten der felderzeugenden Gradientenspule schwingt dann der Parallelresonanzkreis sofort mit der über den zugeordneten Kondensator eingestellten Resonanzfrequenz. Dadurch gibt es praktisch keinen Einschwingvorgang mehr.

In der DE-A-34 15 041 A1 wird eine Stromquelle für eine Gradientenspule beschrieben, bei der Kondensatoren zur Energiespeicherung vorgesehen sind, die nach Bedarf über Schalter in Serie mit der Gradientenspule verbindbar sind. Diese Schaltung wird jedoch nicht als echter Resonanzkreis betrieben.

In der Literaturstelle "Society of Magnetic Resonance in Medicine", 7th Annual Meeting, Books of Abstracts, San Francisco, 20.-26. August 1988, Band 2, Seite 1013, ist ein Serienschwingkreis zur Erzeugung von Gradientenströmen für das SEPI-Verfahren dargestellt. Wie der Serienschwingkreis zum Schwingen gebracht wird, ist nicht angegeben.

In der DE-A-39 02 479 ist eine Vorrichtung beschrieben, bei der separate Gradientenspulen für einen linearen und einen resonanten Betrieb vorgesehen sind. Dabei ist angegeben, daß die Gradientenspulen für den resonanten Betrieb in Serie oder parallel zu einem Kondensator geschaltet werden können.

In der älteren EP-A-0 389 666, die Stand der Technik nach Art. 54 (3) EPÜ darstellt, wird eine Gradientenspule in einem Serienresonanzkreis betrieben. Dabei wird der Einschwingvorgang so gewählt, daß das Strom-Integral vom Zeitpunkt des Einschaltens (t = t0) bis zu einem bestimmten Zeitpunkt (t = t1) gerade Null wird.

Damit wird der Kondensator des Serienschwingkreises auf die notwendige Spannung aufgeladen, ohne daß der Gradientenverstärker diese hohe Spannung liefern muß.

Der Nachteil dieses Verfahrens besteht in der relativ langen Einschwingzeit, die durch Induktivität und Widerstand sowie die Ausgangsspannung des Gradientenverstärkers bedingt ist. Da der Einschwingvorgang mit der relativ hohen Betriebsfrequenz erfolgt, weist auch der frequenzabhängige Widerstand der Gradientenspule einen hohen Wert auf, was die Einschwingzeit wesentlich erhöht.

Aufgabe der Erfindung ist es, ein Verfahren zum Betrieb eines Kernspintomographiegeräts der eingangs genannten Art so auszugestalten, daß die Spannungsbelastung des Gradientenverstärkers und die Einschwingzeit gering bleiben.

Diese Aufgabe wird erfindungsgemäß dadurch gelöst, daß der Resonanzkreis ein Serienresonanzkreis ist und daß die Gradientenspule mit dem Gradientenverstärker über einen ersten Schalter und zusätzlich über die Reihenschaltung eines zweiten Schalters und des Kondensators verbunden ist und wobei die Pulssequenz aus folgenden Schritten besteht:

　　a) bei eingeschaltetem zweiten Schalter beginnt der Serienschwingkreis zu schwingen,
　　b) sobald der Strom durch die Gradientenspule einen Nulldurchgang hat und der Kondensator auf den gewünschten Wert aufgeladen ist, wird der zweite Schalter geöffnet und es erfolgt eine Anregung der Kernspins;

c) es wird eine Gradientenechosequenz angewandt, während derer der zweite Schalter eingeschaltet wird, so daß der Serienresonanzkreis schwingt.

d) bei jedem Scan wird nach einem Anregungspuls ein von Scan zu Scan schrittweise fortgeschalteter Phasencodiergradient und ein Vorphasierpuls in Richtung des Auslesegradienten eingeschaltet und dann je Scan unter einem Auslesegradienten (RO) eine Zeile der Rohdatenmatrix ausgelesen, wobei die Gradientenspule des Serienresonanzkreises den Auslesegradienten erzeugt.

Damit wird der Kondensator ohne Hilfsspannungsquellen auf die benötigte Spannung aufgeladen. Da diese Aufladung vor der Anregung erfolgt, kann nach der Anregung schnell mit dem Auslesen der Echosignale begonnen werden, bevor ein deutlicher Signalverlust durch Relaxation der Kernspins eingetreten ist. Eine derartige Anordnung läßt sich überall dort vorteilhaft einsetzen, wo Gradienten schnell und/oder mit hoher Amplitude geschaltet werden müssen. Die Spannungsbelastung des Gradientenverstärkers wird deutlich geringer als bei Schaltungen mit einem Parallelresonanzkreis.

Durch diese Aufladung des Kondensators kann der Gradientenverstärker auf eine niedrige Spannung ausgelegt werden und es sind keine zusätzlichen Hilfsspannungsquellen erforderlich.

Durch Einschalten des ersten Schalters zwischen den Schritten a) und b) kann vorteilhafterweise ein Vorphasierpuls in Richtung des Auslesegradienten eingeschaltet werden, der so dimensioniert ist, daß das Maximum des Kernresonanzsignales in die Mitte des von der Rohdatenmatrix gebildeten K-Raumes zu liegen kommt. Mit diesem Vorphasierpuls kann die Phasenlage der Kernspins zu Beginn der Signalauslesephase exakt eingestellt werden.

Ein Betrieb bei unterschiedlichen Resonanzfrequenzen ist möglich, indem zur Gradientenspule mehrere Kondensatoren über je einen Schalter in Serie schaltbar sind, so daß der Serienschwingkreis je nach Stellung der Schalter auf unterschiedliche Resonanzfrequenzen einstellbar ist.

Alternativ zu dem erfindungsgemäßen Verfahren nach Anspruch 1 kann das Kernspintomographiegerät auf einfache Weise für den Betrieb ohne Resonanzkreis umgestellt werden, indem der dem Kondensator des Serienschwingkreises parallel geschaltete Schalter geschlossen wird. Bei geschlossenem Schalter wird die Gradientenspule - wie dies bei Sequenzen mit weniger schneller Gradientenumschaltung zweckmäßig ist - direkt mit dem Gradientenverstärker verbunden, d.h. nicht mehr in einem Resonanzkreis betrieben.

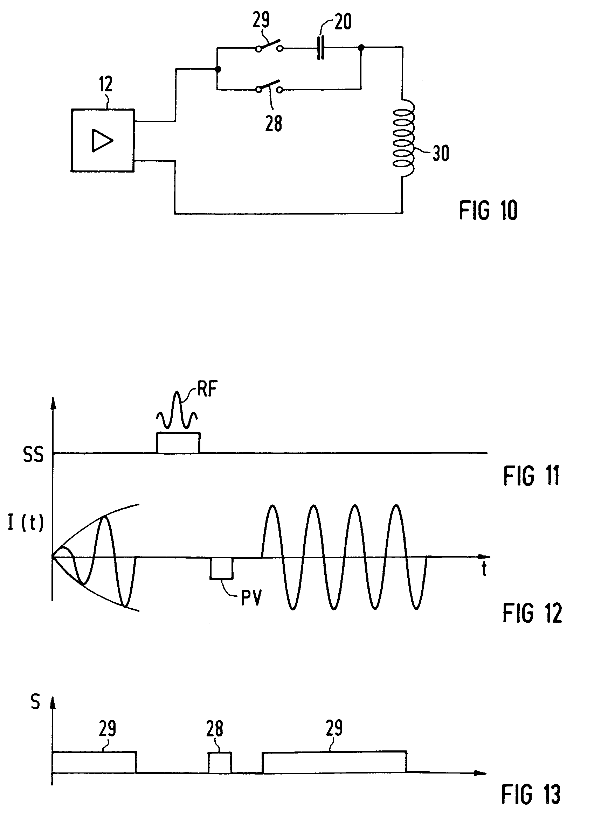

Ein Ausführungsbeispiel der Erfindung wird nachfolgend anhand der FIG 10 bis 20 näher beschrieben. Dabei zeigen:

| FIG 10 | einen Serienschwingkreis mit Aufladung des Kondensators 20, |
| FIG 11 | einen Anregepuls RF mit einem Schichtselektionsgradienten SS, |
| FIG 12 | den Stromverlauf I(t) durch die Gradientenspule 30 mit einem Vorphasierpuls PV, |
| FIG 13 | den Schaltzustand S der Schalter 28 und 29, |
| FIG 14 | eine Schaltungsanordnung, bei der die Resonanzfrequenz umschaltbar ist, |
| FIG 15 bis 19 | die Anwendung der Erfindung bei einer Gradientenechosequenz, |
| FIG 20 | einen Refokussierungspuls. |

In einem Ausführungsbeispiel der Erfindung nach Figur 10 ist die Gradientenspule 30 wahlweise über einen Kondensator 28 direkt oder über einen Schalter 29 in Reihe mit einem Kondensator 20 mit dem Gradientenverstärker 12 verbindbar. Die Wirkungsweise dieser Schaltung wird nachfolgend anhand der FIG 11 bis 13 für eine EPI-Sequenz näher erläutert. Wie in FIG 13 dargestellt, wird vor Beginn der Meßsequenz der Schalter 29 eingeschaltet und der Gradientenverstärker 12 so angesteuert, daß der Serienschwingkreis aus Kondensator 20 und Gradientenspule 30 mit wachsender Amplitude zu schwingen beginnt. Sobald der Kondensator 20 die nötige Ladung aufweist, wird im Stromnulldurchgang der Schalter 29 geöffnet.

Anschließend erfolgt - wie in FIG 11 dargestellt - die Anregung der Kernspins mit einem schichtselektiven Hochfrequenzimpuls RF. Durch Einschalten des Schalters 28 wird ein kurzer Stromimpuls PV über die Gradientenspule 21 geschickt, so daß eine Vorphasierung erfolgt. Anschließend wird wieder der Schalter 29 eingeschaltet. Da der Kondensator 20 aufgeladen ist, beginnt der Serienschwingkreis ohne Einschwingvorgang zu schwingen.

Die Vorphasierung mit dem Stromimpuls PV hat folgenden Zweck:
Beim Fourier-Transformationsverfahren erhält man die besten Bildergebnisse, wenn die Meßwerte mit der höchsten Amplitude in die Mitte des K-Raumes, also der Rohdatenmatrix nach FIG 8 bzw. FIG 9, zu liegen kommen. Dies wird durch eine definierte Vorphasierung in Phasencodier- und Ausleserichtung erzielt.

Zur Erzielung optimaler Bildergebnisse muß die Vorphasierung genau eingestellt werden. Beim Ausführungsbeispiel einer Pulssequenz nach FIG 12 ist daher vor der Auslesephase ein Stromimpuls PV zur Vorphasierung eingeschaltet. Durch die Länge bzw. Amplitude dieses Stromimpulses PV kann der erforderliche Wert der Vorphasierung genau eingestellt werden.

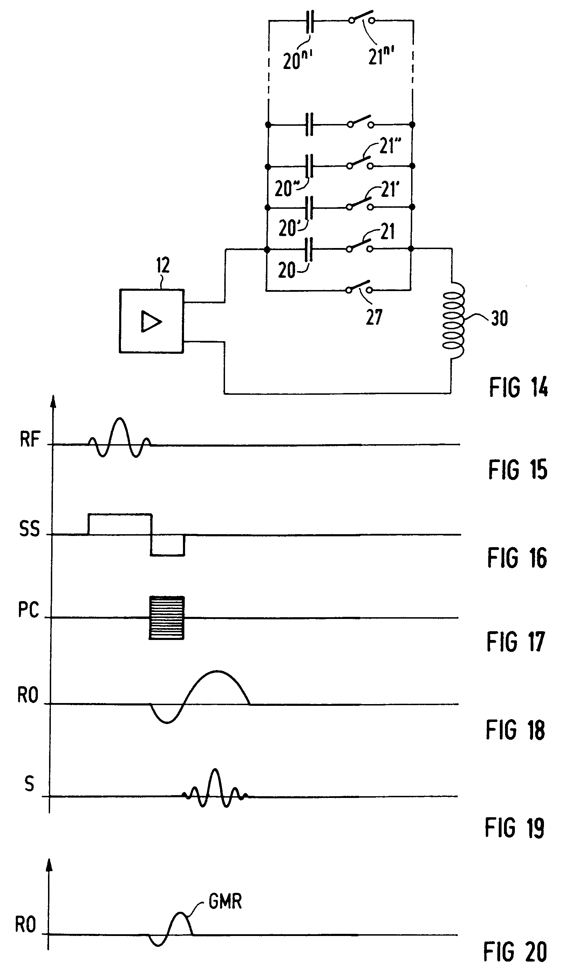

Der Serienresonanzkreis kann auch für mehrere Resonanzfrequenzen ausgelegt sein, indem - wie in FIG 14 dargestellt - mehrere Kondensatoren 20 bis 20n' über Schalter 21 bis 21n' mit der Gradientenspule 30 zu einem Serienschwingkreis zusammenschaltbar sind.

Es ist zu betonen, daß die beschriebene Schaltung nicht nur für Pulssequenz nach dem in den FIG 2 bis 9 dargestellten EPI-Verfahren vorteilhaft eingesetzt werden können, sondern überall dort, wo Gradienten schnell und/oder mit hoher Amplitude geschaltet werden müssen.

Als weiteres Ausführungsbeispiel ist in den FIG 15 bis 19 eine normale Gradientenechosequenz dargestellt. Dabei wird zunächst ein Hochfrequenz-Anregungspuls RF unter der Wirkung eines Schichtselektionsgradienten SS eingestrahlt. Anschließend wird die durch den Schichtselektionsgradienten SS verursachte Phasendrehung rephasiert, ein von Scan zu Scan schrittweise veränderlicher Phasenkodiergradient PC wird eingeschaltet und schließlich werden die Spins durch einen negativen Impuls in Ausleserichtung dephasiert. Durch den anschließenden Auslesegradienten RO entsteht als Signal S ein Echosignal. Auch hierbei kann man, wie in FIG 18 dargestellt, dem Auslesegradienten RO eine Sinusform geben und ihn somit mit einem Serienschwingkreis erzeugen.

Ferner kann man mit der beschriebenen Schaltung auch eine Flußrephasierung mit einem sogenannten GMR(gradient motion refocussing)-Gradienten erzeugen, wie dies in FIG 20 dargestellt ist. Mit einem solchen Gradienten in Ausleserichtung kann man die Dephasierung der Spins in einem bewegten Medium rückgängig machen, wie dies in der Literaturstelle "Journal of Computer Assisted Tomography", Vol. 12, Nr. 3, 1988, beschrieben ist. Wenn man diesem GMR-Puls eine Sinusform gibt, kann er ebenfalls vorteilhaft mit einem Serienschwingkreis der dargestellten Art erzeugt werden.

Die bei den Pulsen nach den FIG 18 und 20 ungleichen Zeitdauern der positiven und negativen Teilimpulse kann man durch Frequenzumschaltung des Serienresonanzkreises erreichen, beispielsweise durch Umschaltung der Kondensatoren beim Ausführungsbeispiel nach FIG 14.

**Patentansprüche**

1. Verfahren zum Betrieb eines Kernspintomographiegeräts mit einer Pulssequenz, bei der je Scan nach einer Anregung eine Auslesesequenz folgt, bei der mindestens zwei senkrecht aufeinander stehende Gradienten (RO, PC) zur Ortscodierung eingeschaltet werden, wobei die entstehenden Signale digitalisiert und im K-Raum in eine Rohdatenmatrix eingeschrieben werden, wobei aus der Rohdatenmatrix durch eine mindestens zweidimensionale Fouriertransformation ein Bild gewonnen wird, wobei mindestens eine Gradientenspule (30) mit mindestens einem Kondensator (20) zu einem Resonanzkreis zusammengeschaltet ist, der an einen Gradientenverstärker (12) angeschlossen ist, wobei der Gradientenverstärker (12) nach einer vorbestimmten Zeitfunktion angesteuert wird, **dadurch gekennzeichnet,** daß der Resonanzkreis ein Serienresonanzkreis ist und daß die Gradientenspule (30) mit dem Gradientenverstärker (12) über einen ersten Schalter (28) und zusätzlich über die Reihenschaltung eines zweiten Schalters (29) und des Kondensators (20) verbunden ist und wobei die Pulssequenz aus folgenden Schritten besteht:

a) bei eingeschaltetem zweiten Schalter (29) beginnt der Serienschwingkreis zu schwingen,
b) sobald der Strom (I) durch die Gradientenspule (30) einen Nulldurchgang hat und der Kondensator (20) auf den gewünschten Wert aufgeladen ist, wird der zweite Schalter (29) geöffnet und es erfolgt eine Anregung der Kernspins;
c) es wird eine Gradientenechosequenz angewandt, während derer der zweite Schalter (29) eingeschaltet wird, so daß der Serienresonanzkreis (20,30) schwingt.
d) bei jedem Scan wird nach einem Anregungspuls (RF) ein von Scan zu Scan schrittweise fortgeschalteter Phasencodiergradient (PC) und ein Vorphasierpuls (PV) in Richtung des Auslesegradienten (RO) eingeschaltet und dann je Scan unter einem Auslesegradienten (RO) eine Zeile der Rohdatenmatrix ausgelesen, wobei die Gradientenspule (30) des Serienresonanzkreises den Auslesegradienten (RO) erzeugt.

2. Verfahren nach Anspruch 1, **dadurch gekennzeichnet,** daß durch Einschalten des ersten Schalters (28) zwischen den Schritten b) und c) ein Vorphasierpuls (PV) erzeugt wird.

3. Verfahren nach Anspruch 1 oder 2, **dadurch gekennzeichnet,** daß zur Gradientenspule (30) mehrere Kondensatoren (20 bis 20n') über je einen Schalter (21 bis 21n') in Serie schaltbar sind, so daß der Serienschwingkreis je nach Stellung der Schalter (21 bis 21n') auf unterschiedliche Resonanzfrequenzen einstellbar ist.

4. Verfahren nach einem der Ansprüche 1 bis 3, **dadurch gekennzeichnet,** daß der erste Schalter (28) bei Ansteuerung der Gradientenspule (30) ohne Resonanzkreis geschlossen wird.

5. Verfahren nach einem der Ansprüche 1 bis 4, **dadurch gekennzeichnet,** daß eine Pulssequenz nach dem Echoplanar-Verfahren verwendet wird, wobei während der Auslesesequenz ein aus Teilimpulsen mit wechselnder Polarität bestehender Auslesegradient und ein Phasenkodiergradient eingeschaltet werden, wobei je Teilimpuls des Auslesegradienten eine Zeile der Rohdatenmatrix ausgelesen wird und wobei die Gradientenspule (30) des Serienresonanzkreises den Auslesegradienten (RO) erzeugt.

6. Verfahren nach einem der Ansprüche 1 bis 5, **dadurch gekennzeichnet,** daß mit der Gradientenspule (30) des Serienresonanzkreises ein aus einem negativen und einem positiven Teilimpuls zusammengesetzter Refokussierungspuls (GMR) für Kernresonanzsignale aus bewegten Quellen erzeugt wird.

FIG 1

RF

FIG 2

SS

FIG 3

PC

PCV

FIG 4

PC

PCV

FIG 5

RO

FIG 6

S

FIG 7

FIG 8

FIG 9

FIG 10

FIG 11

FIG 12

FIG 13

FIG 14

FIG 15

FIG 16

FIG 17

FIG 18

FIG 19

FIG 20

EP 0 722 093 A1

| | | | Europäisches | EUROPÄISCHER RECHERCHENBERICHT | | Nummer der Anmeldung |
|---|---|---|---|---|---|---|
| | | | Patentamt | | | EP 96 10 0084 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| A,D | SOCIETY OF MAGNETIC RESONANCE IN MEDICINE, SEVENTH ANNUAL MEETING AND EXHIBITION, BOOKS OF ABSTRACTS, Bd. 2, 20.August 1988 SAN FRANCISCO, CA, US, Seite 1013 XP 000088185 J.H. KIM ET AL. 'WHOLE BODY NMR SPIRAL-SCAN ECHO PLANAR IMAGING (SEPI) USING RESONANT GRADIENT COIL' * das ganze Dokument * --- | 1,5 | G01R33/385 G01R33/561 |
| A,D | DE-A-39 02 479 (KABUSHIKI KAISHA TOSHIBA) 10.August 1989 * Seite 2, Zeile 8 - Zeile 67 * * Seite 4, Zeile 22 - Zeile 67 * --- | 1,5 | |
| A,D | EP-A-0 227 411 (NATIONAL RESEARCH DEVELOPMENT CORPORATION) 1.Juli 1987 * Zusammenfassung * * Seite 2, Zeile 22 - Seite 4, Zeile 33 * * Seite 9, Zeile 23 - Seite 12, Zeile 8 * --- | 1 | |
| A,D | DE-A-34 15 041 (INSTRUMENTARIUM CORP.) 25.Oktober 1984 * Zusammenfassung * * Seite 6, Zeile 3 - Seite 8, Zeile 8 * * Seite 12, Zeile 1 - Zeile 22 * --- | 1 | RECHERCHIERTE SACHGEBIETE (Int.Cl.5) G01R |
| A | DE-A-36 43 577 (MAX-PLANCK-GESELLSCHAFT ZUR FÖRDERUNG DER WISSENSCHAFTEN E.V.) 30.Juni 1988 * Zusammenfassung * * Spalte 7, Zeile 7 - Zeile 32 * --- -/-- | 1 | |

Der vorliegende Recherchenbericht wurde für alle Patentansprüche erstellt

| Recherchenort | Abschlußdatum der Recherche | Prüfer |
|---|---|---|
| DEN HAAG | 28.März 1996 | Horak, G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes Dokument

EPO FORM 1503 03.82 (P04C03)

11

**Europäisches Patentamt**

# EUROPÄISCHER RECHERCHENBERICHT

Nummer der Anmeldung

EP 96 10 0084

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| A | JOURNAL OF PHYSICS E SCIENTIFIC INSTRUMENTS., Bd. 13, 1980 BRISTOL GB, Seiten 947-955, J.M.S. HUTCHISON ET AL. 'A WHOLE-BODY NMR IMAGING MACHINE' * das ganze Dokument * | 1 | |
| A | JOURNAL OF PHYSICS E SCIENTIFIC INSTRUMENTS., Bd. 15, 1982 BRISTOL GB, Seiten 74-79, G. JOHNSON ET AL. 'INSTRUMENTATION FOR NMR SPIN-WARP IMAGING' * das ganze Dokument * | 1 | |
| | | | RECHERCHIERTE SACHGEBIETE (Int.Cl.5) |

Der vorliegende Recherchenbericht wurde für alle Patentansprüche erstellt

| Recherchenort | Abschlußdatum der Recherche | Prüfer |
|---|---|---|
| DEN HAAG | 28.März 1996 | Horak, G |

EPO FORM 1503 03.82 (P04C03)